# EUROPEAN PATENT APPLICATION

(11) **EP 1 638 134 A2**
(43) Date of publication of application: **22.03.2006**
(21) Application number: 05018279.9
(22) Date of filing: 23.08.2005
(51) Int. Cl.: H01L 21/00

(54) **Thin plate supporting container**

(30) Priority: 26.08.2004 JP 2004247161
(71) Applicant: Miraial Co., Ltd., Tokyo (JP)
(72) Inventor: Obayashi, Tadahiro, Shisui-machi Kikuchi-shi Kumamoto-ken (JP)
(74) Representative: Grünecker, Kinkeldey, Stockmair & Schwanhäusser Anwaltssozietät

(57) **Abstract**

Particle adhesion to a gap between a container main body and a lid unit is reduced to prevent the particle intrusion into the container main body. The inside of a thin plate supporting container is kept clean, and semiconductor wafers and the like are stored in the thin plate supporting container. The thin plate supporting container includes the container main body in which the semiconductor wafers are stored and the lid unit which blocks the container main body. In the thin plate supporting container, a protection film is provided while the gap between the lid unit and the container main body is covered with the protection film. Adhesion properties are imparted to the protection film, so that the protection film is easy to attach and detach. The protection film is formed in a size in which the entire side surface of the lid unit of the container main body is covered with the protection film. The lid unit is attached to the entire side surface of the container main body. The particles are prevented from intruding into the gap between the lid unit and the container main body by bonding the protection film. Therefore, the particles are prevented from intruding into the container main body along with the entrained air when the lid unit is detached from the container main body.

## Description

### BACKGROUND OF THE INVENTION

The present invention relates to a thin plate supporting container used for storage, transport, and the like of thin plates such as semiconductor wafers, storage disks, and liquid crystal glass substrates while the inside of the container is kept clean.

The thin plate supporting container used for the storage and transport of the thin plates such as the semiconductor wafers is well known.

The thin plate supporting container mainly includes a container main body and a lid unit with which an upper opening of the container main body is covered. A member which supports the thin plates such as the semiconductor wafer is provided inside the container main body. In order to prevent contamination of a surface of the thin plate such as the semiconductor wafer stored in the thin plate supporting container, it is necessary to transport the thin plate supporting container while the inside of the container is kept clean, so that the thin plate supporting container is sealed. That is, the lid unit is fixed to the container main body to seal the container main body.

When the thin plate is taken out from and put in the inside of the thin plate supporting container, the lid unit is detached from the container main body to release the inside, and the thin plate is automatically taken out and put in by a transfer machine.

An example of the thin plate supporting container is disclosed in Japanese Patent Application Laid-Open No. 2003-174080.

However, in the above-described lid unit, when the lid unit is detached from the container main body, a negative pressure is temporarily created in the inside of the container main body, which results in an air entrainment phenomenon in a gap between the container main body and the lid unit.

In this case, when particles exist in the gap between the container main body and the lid unit, the particles intrude into the container main body along with the entrained air to contaminate the surface of the thin plate.

### SUMMARY OF THE INVENTION

In view of the foregoing, an object of the invention is to provide a thin plate supporting container which reduces the particle adhesion to the gap between the container main body and the lid unit to prevent the particle intrusion.

According to the present invention, there is provided a thin plate supporting container which stores thin-plates therein while the inside of the container is kept clean comprising a container main body in which the thin-plates are stored; and a lid unit which blocks the container main body, wherein a protection film is provided while a gap between the lid unit and the container main body is covered with the protection film.

According to the above configuration, since the gap between the lid unit and the container main body is covered with the protection film, the particles cannot intrude into the gap between the lid unit and the container main body. Therefore, the particles are prevented from intruding into the container main body along with the entrained air, when the lid unit is detached from the container main body.

It is desirable that adhesion properties are imparted to the protection film. Therefore, the protection film is easy to attach and detach after the thin plates are stored in the container main body to attach the lid unit. Further, when the thin plates are taken out at the destination, the protection film can easily be peeled off.

It is desirable that the protection film is formed in a size in which the protection film covers the entire side surface of the lid unit in the container main body to which the lid unit is attached. Therefore, even when the lid unit has a complicated structure due to an attaching/detaching mechanism and the like, because the particle intrusion into the gap of such the complicated mechanism is eliminated, the particles which potentially intrude into the gap between the lid unit and the container main body from the surroundings are eliminated, and the particles which intrude into the container main body from the gap between the lid unit and the container main body can be largely reduced.

When the lid unit has a simple structure having no attaching/detaching mechanism, because a small number of particles potentially intrude into the gap between the lid unit and the container main body from the surroundings, the protection film may be provided such that a perimeter of the gap between the lid unit and the container main body is covered with the protection film.

### BRIEF DESCRIPTION OF THE DRAWINGS

Fig. 1 is a perspective view showing a thin plate supporting container according to an embodiment of the invention; and
Fig. 2 is a perspective view showing a modification.

### DESCRIPTION OF THE PREFERRED EMBODIMENT

Referring now to the accompanying drawings, a preferred embodiment of the invention will be described below. The thin plate supporting container of the invention is one which is used for the storage, the transport, and the like while the thin plates such as the semiconductor wafers, the storage disks, and the liquid crystal glass substrates are stored in the thin plate supporting container. The thin plate supporting container in which the semiconductor wafers are stored will be described by way of illustration.

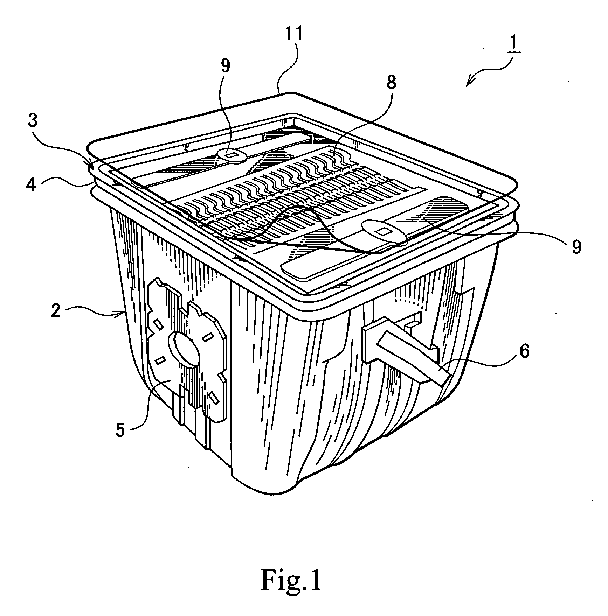

As shown in Fig. 1, a thin plate supporting container 1 according to an embodiment includes a container main body 2 in which a plurality of semiconductor wafers (not shown) are stored and a lid unit 3 which blocks the container main body 2.

The entire container main body 2 is formed in a substantial cube. When the container main body 2 is placed in a vertical position as shown in Fig. 1, a lid unit holder 4 into which the lid unit 3 is fitted is provided in an upper end portion of the container main body 2. The lid unit holder 4 is formed while the upper end portion of the container main body 2 is enlarged to dimensions of the lid unit 3. Therefore, the lid unit 3 is fitted in the lid unit holder 4 to seal the inside of container main body 2.

A thin plate holder (not shown), which supports the semiconductor wafers stored inside the container main body 2 from both sides, is provided in the container main body 2. A top flange 5 which is grasped by an arm of a conveying apparatus (not shown) in a factory, a carrying handle 6 which an operator grasps when the operator manually carries the thin plate supporting container 1, positioning means (not shown), and the like are provided in an outside surface of the container main body 2.

The lid unit 3 is formed in a rectangle thick plate. The lid unit 3 is fitted in the lid unit holder 4 of the container main body 2 to seal the inside of the container main body 2. A wafer retainer 8 is provided in a lower surface of the lid unit 3. The wafer retainer 8 supports the semiconductor wafers stored inside the container main body 2 from the upper side. A simplified attaching/detaching mechanism 9 is provided in an upper surface of the lid unit 3. The simplified attaching/detaching mechanism 9 is a device which fixes the lid unit 3 to the container main body 3 side, and the simplified attaching/detaching mechanism 9 has a lid unit latch pawl which emerges from an outer peripheral surface of the lid unit 3.

A sealing member (not shown) which is seals the inside of the container main body 2 is provided between the lid unit holder 4 and the lid unit 3. The inside of the container main body 2 is kept clean by sealing the container main body 2 with the sealing member, and the particles are prevented from intruding into the container main body 2.

A protection film 11 is provided in the upper surface (surface on the lid unit 3 side) of the container main body 2 to which the lid unit 3 is attached. The protection film 11 is one which prevents the particles from intruding into the gap between the container main body 2 and the lid unit 3. The protection film 11 is formed in a size in which the entire upper surface of the container main body 2 is covered with protection film 11. The reason why the protection film 11 is formed in the above size is that the particles intrusion from the simplified attaching/detaching mechanism 9 side is considered. That is, in consideration of both the particles which directly intrude into an area near the sealing member from the gap between the container main body 2 and the lid unit 3 and the particles which intrude into the gap from an emerging hole of the lid unit latch pawl of the simplified attaching/detaching mechanism 9, the protection film 11 is formed in the size in which the entire upper surface of the container main body 2 is covered with the protection film 11. The protection film 11 is formed by an air-impermeable transparent plastic film.

Adhesion properties are imparted to a backside of the protection film 11 such that the protection film 11 is attachable to and detachable from the container main body 2 and the lid unit 3. Adhesion strength of the backside of the protection film 11 is set such that the gap between the container main body 2 and the lid unit 3 can be sealed by bonding the protection film 11 easily, and the protection film 11 can easily be peeled off.

The thin plate supporting container 1 having the above configuration is used in the following way.

First, the lid unit 3 of the thin plate supporting container 1 is detached from the container main body 2, and the plurality of semiconductor wafers are stored in the container main body 2. Then, the lid unit 3 is attached to the lid unit holder 4 of the container main body 2 to fix the container main body 2 and the lid unit 3 each other with the simplified attaching/detaching mechanism 9. Then, the protection film 11 is adhered to cover the container main body 2 and the entire upper surface of the lid unit 3.

In the state of things, the thin plate supporting container 1 is conveyed. In conveying the thin plate supporting container 1, the particles adhere to the outer periphery of the thin plate supporting container 1. At this point, near the lid unit 3 of the thin plate supporting container 1, the entire upper surface of the container main body 2 is covered with the protection film 11 while the lid unit 3 is completely covered with the protection film 11. Therefore, the particles can be prevented from intruding into the gap between the container main body 2 and the lid unit 3 and the simplified attaching/detaching mechanism 9.

After the thin plate supporting container arrives at a destination, the protection film 11 is peeled off, the lid unit 3 is detached from the container main body 2, and the semiconductor wafers are taken out from the inside of the container main body 2.

As described above, since the gap between the container main body 2 and the lid unit 3 is covered with the protection film 11, the particles do not intrude into the gap between the container main body 2 and the lid unit 3, and the particles are not entrained inside the container main body 2 along with the air when the lid unit 3 is detached from the container main body 2. Accordingly, when the lid unit 3 is detached, the inside of the container main body 2 can also be kept clean, and the semiconductor wafers stored in the container main body 2 can be prevented from contaminating the surface.

Since the adhesion properties are imparted to the protection film 11, the protection film 11 can easily be adhered and peeled off, which improves workability in conveying the thin plate supporting container 1.

Since protection film 11 is formed in the size in which the entire surface on the lid unit 3 side of the container main body 2 to which the lid unit 3 is attached is covered with protection film 11, the particles can be prevented from intruding into the gap between the container main body 2 and the lid unit 3 and the gap of the simplified attaching/detaching mechanism 9 in the lid unit 3. Therefore, the particles which intrude into the gap between the container main body 2 and the lid unit 3 from the emerging hole of the lid unit latch pawl of the simplified attaching/detaching mechanism 9 can be eliminated while the particles which directly intrude into the gap between the container main body 2 and the lid unit 3 can be eliminated, which allows the particles to be prevented from intruding into the container main body 2 from the gap between the container main body 2 and the lid unit 3 in opening the thin plate supporting container 1. Accordingly, when the lid unit 3 is detached, the inside of the container main body 2 can also be kept clean, and the semiconductor wafers stored in the container main body 2 can be prevented from contaminating.

### Modifications

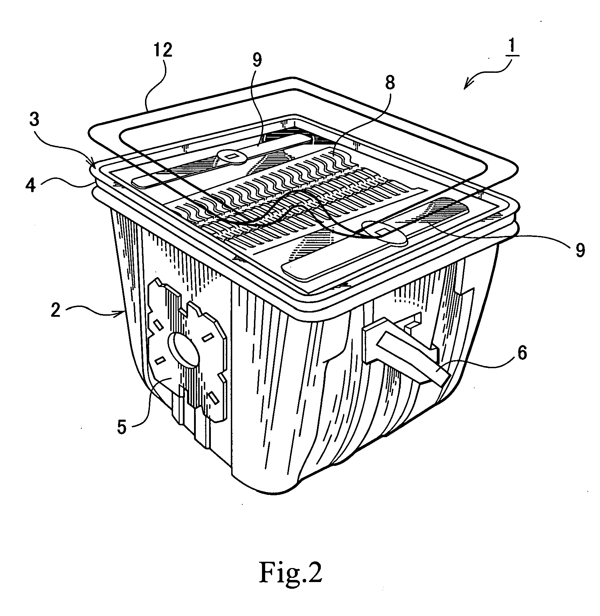

(1) In the above embodiment, the protection film 11 is formed in the size in which the entire surface of the container main body 2 to which the lid unit 3 is attached is covered with the protection film 11. However, as shown in Fig. 2, a protection film 12 may be formed in a rectangular annular shape such that only a perimeter of the gap between the container main body 2 and the lid unit 3 is covered with the protection film 12. In the case of the lid unit 3 having a simple structure in which the simplified attaching/detaching mechanism 9 and the like do not exist, because a small number of particles potentially intrude into the gap between the container main body 2 and the lid unit 3 from the surroundings, the protection film 11 may be formed such that only the perimeter of the gap between the container main body 2 and the lid unit 3 is covered with the protection film 11.
   Accordingly, the inside of the container main body 2 can be kept clean with the simple structure, and the semiconductor wafers stored in the container main body 2 can be prevented from contaminating.
(2) In the above embodiment, the adhesion properties are imparted to the entire backside of the protection film 11. However, the adhesion properties may be imparted to only the peripheral portion of the rectangle protection film 11. Further, the adhesion properties may not be imparted to the surface facing to the gap between the container main body 2 and the lid unit 3, but the surface may be charged to absorb the particles. In this case, a sheet having an electrostatic property is bonded to the surface facing to the gap between the container main body 2 and the lid unit 3 in the protection film 11. When only the surface facing the gap between the container main body 2 and the lid unit 3 can be charged in the protection film 11, only the surface facing the gap is charged. The entire lower surface of the protection film 11 may be charged. The sheet having an electrostatic property may be bonded to the entire lower surface of the protection film 11. In this case, needless to say, the upper surface of the protection film 11 is not charged.
(3) The thin plate supporting container 1 of Fig. 1 is shown by way of illustration in the above embodiment. However, the invention is not limited to the thin plate supporting container 1, but the invention can also be applied to all the thin plate supporting containers having the structure in which the gap is formed between the container nain body 2 and the lid unit 3. Even if this case, the same operations and effects as for the embodiment can be achieved.

## Claims

1. A thin plate supporting container which stores thin-plates therein while the inside of the container is kept clean, the container comprising:
a container main body in which the thin-plates are stored; and
a lid unit which blocks the container main body,
wherein a protection film is provided while a gap between the lid unit and the container main body is covered with the protection film.

2. A thin plate supporting container according to claim 1, wherein adhesion properties are imparted to the protection film such that the protection film is attachable to and detachable from the lid unit and the container main body.

3. A thin plate supporting container according to claim 1 or 2, wherein the protection film covers the entire side surface of the lid unit in the container main body to which the lit unit is attached.

4. A thin plate supporting container according to claim 1 or 2, wherein the protection film covers the entire perimeter of the gap between the lid unit and the container main body in the container main body to which the lid unit is attached.
